# EUROPÄISCHE PATENTSCHRIFT

(11) **EP 1 199 722 B1**
(45) Veröffentlichungstag und Bekanntmachung des Hinweises auf die Patenterteilung: **29.12.2004**
(21) Anmeldenummer: 01120332.0
(22) Anmeldetag: 24.08.2001
(51) Int. Cl.: G11C 7/06, G11C 7/22, G11C 11/4091

(54) **Schaltungsanordnung zur Generierung von Leseverstärker-Steuersignalen**
Circuit for generating sense amplifer control signals
Circuit pour la génération de signaux de contrôle d'amplificateur de lecture

(30) Priorität: 18.10.2000 DE 10051613
(43) Veröffentlichungstag der Anmeldung: 24.04.2002
(73) Patentinhaber: Infineon Technologies AG, 81669 München (DE)
(72) Erfinder: Chrissostomidis, Ioannis, 81927 München (DE); Schaffroth, Thilo, 85244 Roehrmoos (DE); Fischer, Helmut, Dr., 82024 Taufkirchen (DE)
(74) Vertreter: Müller - Hoffmann & Partner

(56) Entgegenhaltungen:
- EP-A- 0 813 206
- US-A- 5 936 905
- DIODATO P W: "EMBEDDED DRAM: MORE THAN JUST A MEMORY" IEEE COMMUNICATIONS MAGAZINE, IEEE SERVICE CENTER. PISCATAWAY, N.J, US, Bd. 38, Nr. 7, Juli 2000 (2000-07), Seiten 118-126, XP000969721 ISSN: 0163-6804

## Beschreibung

Die vorliegende Erfindung betrifft eine Schaltungsanordnung zur Generierung von Leseverstärker-Steuersignalen für einen Speicher, bei dem über einen ersten Strompfad eine adressierte Wortleitung WL des Speichers aktivierbar ist, umfassend einen zweiten Strompfad, in dem aus einem von dem ersten Strompfad abgeleiteten Signal in einer Steuereinrichtung die Leseverstärker-Steuersignale erzeugt sind, und eine Spannungsversorgungseinrichtung für Bauelemente des ersten und des zweiten Strompfades.

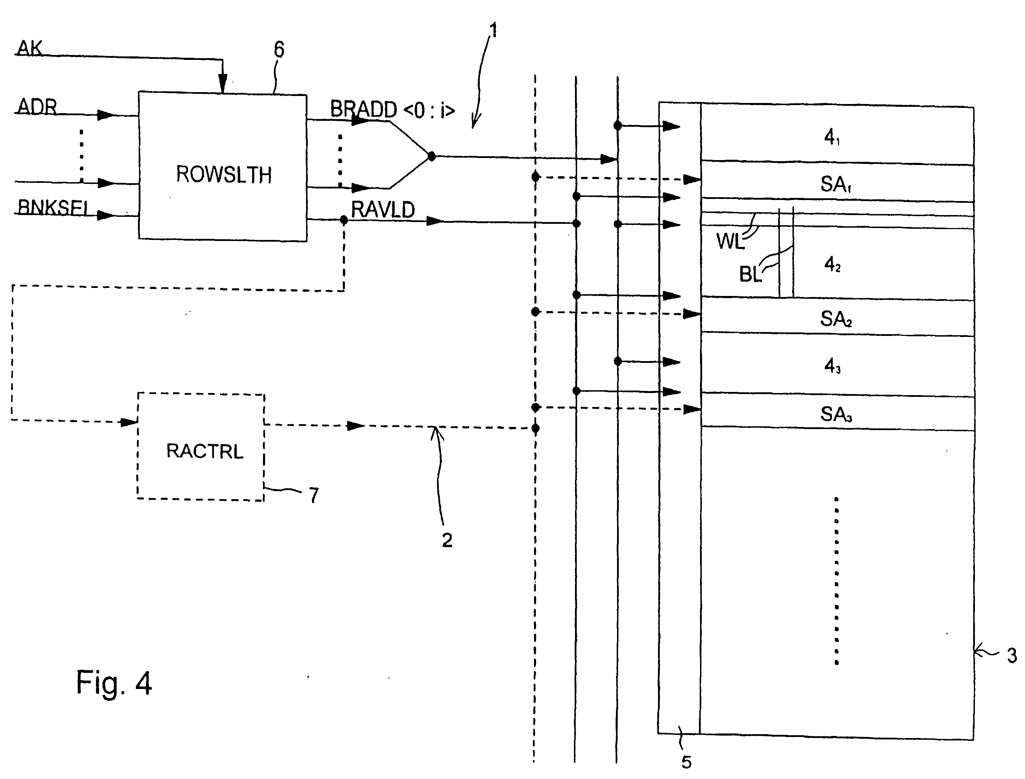

Fig. 4 zeigt eine bestehende Schaltung mit einem ersten Strompfad 1 in Volllinien und einem zweiten Strompfad 2 in Strichlinien für einen Speicher, wie z. B. einen DRAM, mit einem Speicherzellenfeld 3 aus Array-Blöcken 4₁, 4₂, ... von Speicherbänken, zwischen denen sich jeweils Leseverstärker bzw. Senseamps SA₁, SA₂, ... befinden, und aus Wortleitungsdecodern 5 für jeweils eine Vielzahl von Wortleitungen WL (nur zwei Wortleitungen gezeigt), die in den einzelnen Array-Blöcken 4₁, 4₂, ... zu den einzelnen Reihen von Speicherzellen der Speicherbänke in den Array-Blöcken 4₁, 4₂, ... führen. Bitleitungen BL verlaufen im wesentlichen senkrecht zu den Wortleitungen WL (nur zwei Bitleitungen sind schematisch gezeigt).

Der erste Strompfad 1 dient zur Aktivierung einer adressierten Wortleitung WL: Eine Bank- und Zeilenadresse BNKSEL bzw. ADR wird gemeinsam mit einem Aktivierungskommando AK in die Schaltung eingespeist und in einer dafür vorgesehenen Steuerschaltung 6 bzw. ROWSLTH (= Row Slave Latch) gespeichert. In der Steuerschaltung 5 wird ein Signal RAVLD (Row Address Valid) erzeugt, das dazu verwendet wird, die partielle Decodierung von i + 1 Zeilenadressen BRADD (Bank Row Address) einzuleiten und den entsprechenden Array-Block 4₁, 4₂, ... auszuwählen. In dem ausgewählten Array-Block wird die Zeilenadresse weiterverarbeitet und soweit decodiert, dass damit eine Wortleitung WL ausgewählt werden kann.

In diesem Zusammenhang soll am Rand angemerkt werden, dass parallel zu dem obigen Prozess in allen Array-Blöcken 4₁, 4₂, ... durch das Signal RAVLD ein Vergleich der jeweiligen Zeilenadresse mit den Adressen von reparierten Wortleitungen vorgenommen wird. Bei Übereinstimmung (Redundanztreffer) wird eine dazugehörige redundante Wortleitung aktiviert. Die vordecodierte Zeilenadresse ist dann nicht mehr relevant. Wenn kein Redundanztreffer vorliegt, wird aus der vordecodierten Zeilenadresse die entsprechende Wortleitung ausgewählt und aktiviert. Dieser Vorgang ist aber für das Verständnis der Erfindung von untergeordneter Bedeutung.

Entlang der ausgewählten Wortleitungen WL (oder redundanten Wortleitungen) werden sodann mittels der Auswahltransistoren der Speicherzellen die Zellinhalte der adressierten Speicherzellen, also gespeicherte Daten, auf die Bitleitungen dieser Speicherzellen übertragen.

Im zweiten Strompfad 2 werden Signale generiert, welche die zugehörigen Leseverstärker SA₁, SA₂, ... ansteuern. Diese dürfen aber erst aktiviert werden, wenn die Inhalte der adressierten Speicherzellen sicher auf die Bitleitungen übertragen sind.

Um dies zu gewährleisten, wird im zweiten Strompfad 2, der insbesondere einen Senseamp-Timer 7 (RACTRL) enthält, aus dem Signal RAVLD eine Verzögerung abgeleitet, die der maximalen Verzögerung im ersten Strompfad 1 einschließlich des Datentransfers auf die Bitleitungen entspricht.

Die Schaltungen im ersten Strompfad 1 bestehen zum Teil aus Dünnoxidtransistoren und zum Teil aus Dickoxidtransistoren. Die Dünnoxidtransistoren verwenden die Standardversorgungsspannung Vint, während die Dickoxidtransistoren mit der gegenüber der Standardversorgungsspannung Vint erhöhten Versorgungsspannung VPP betrieben sind.

Das Timing (Zeitsteuerung) von Leseverstärkern eines Speichers mit einem Speicherzellenfeld wird derzeit für jeden Quadranten dieses Speicherzellenfeldes in dem für den jeweiligen Quadranten zentralen Senseamp-Timer 7 erzeugt. Durch dieses Timing, bei dem unter anderem das erwähnte, die Gültigkeit von Zeilenadressen signalisierende Startsignal RAVLD ausgewertet wird, wird der Startzeitpunkt für die Bewertung der aus dem Speicherzellenfeld ausgelesenen Zellsignale einer Bitleitung festgelegt.

Für einen schnellstmöglichen Datenzugriff ist es nun wichtig, dass bei der Aktivierung einer Zeile des Speicherzellenfeldes die zeitlichen Abläufe jeweils möglichst genau und identisch reproduzierbar sind. Mit anderen Worten, unabhängig davon, auf welche Zeile des Speicherzellenfeldes zugegriffen wird, sollte der zeitliche Ablauf bei jedem Datenzugriff möglichst genau nachzubilden sein.

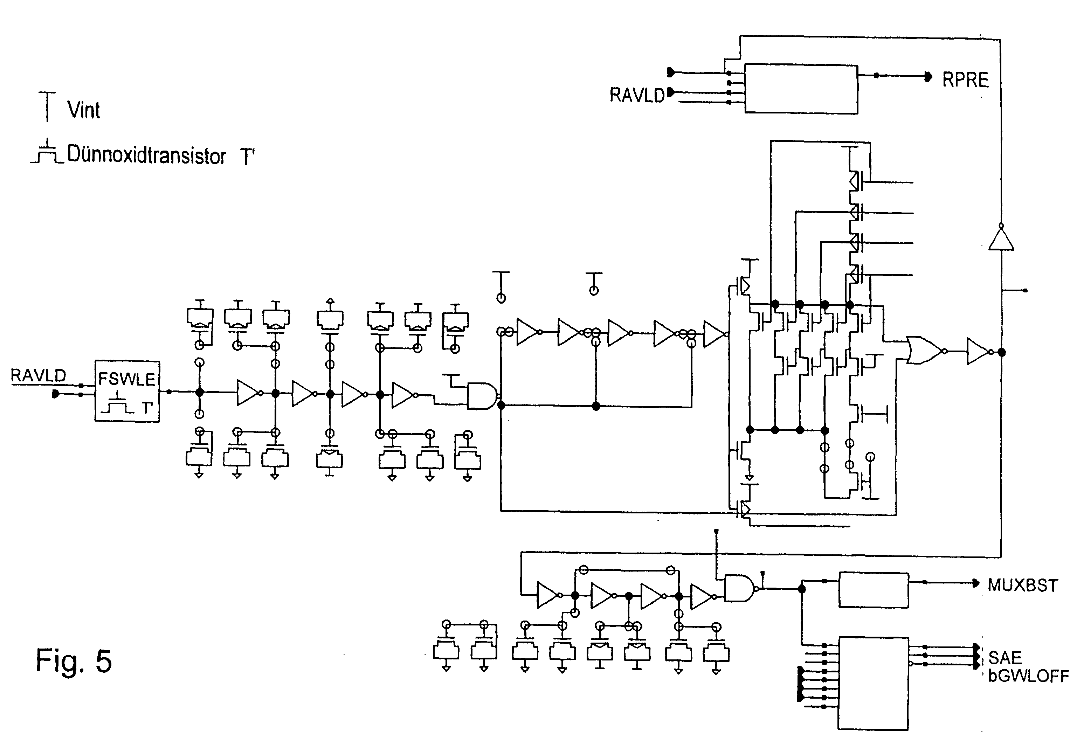

Fig. 5 zeigt den zweiten Strompfad für das von der Steuerschaltung 6 gelieferte Timer-Startsignal RAVLD in einem bestehenden DRAM, also insbesondere den Senseamp-Timer 7. Dieser zweite Strompfad 2 weist hauptsächlich Inverter und Dünnoxidtransistoren auf, die durch eine Standardversorgungsspannung Vint betrieben sind. Aus dem Startsignal RAVLD werden dabei Signale RPRE (Row Precharge), MUXBST (Multiplexer Boost), SAE (Senseamp Enable) und bGWLOFF (Wortleitung-Aus) erzeugt. FSWLE bedeutet eine Grundverzögerungsschaltung.

Es ist nun Aufgabe der vorliegenden Erfindung, eine Schaltungsanordnung zur Generierung von Leseverstärker-Steuersignalen für einen Speicher zu schaffen, die bei Aktivierung in ihrem Verhalten trotz technologisch bedingter Schwankungen und Veränderungen der Spannungen möglichst weitgehend an den ersten Strompfad angepasst ist, sodass die beiden Strompfade weitgehend aneinander angeglichen sind, was auch für technologische Schwankungen gilt, die bei der Herstellung des Speichers auftreten.

Diese Aufgabe wird bei einem Senseamp-Timer der eingangs genannten Art erfindungsgemäß dadurch gelöst, dass im zweiten Strompfad zusätzlich Dickoxidtransistoren vorgesehen sind, und dass von der Spannungsversorgungseinrichtung die Dünnoxidtransistoren mit normaler Versorgungsspannung Vint und die Dickoxidtransistoren mit erhöhter Versorgungsspannung VPP betrieben sind.

Bei der erfindungsgemäßen Schaltungsanordnung, also im Strompfad für das Startsignal RAVLD, werden also - wie im ersten Strompfad - sowohl Dünnoxidtransistoren, die mit der Standardversorgungsspannung Vint betrieben sind, als auch Dickoxidtransistoren, die mit der erhöhten Versorgungsspannung VPP betrieben sind, eingesetzt. Dabei wird die Grundverzögerung nach wie vor durch die Dünnoxidtransistoren eingestellt, wobei im Strompfad diesen Dünnoxidtransistoren aber Dickoxidtransistoren folgen, die mit der erhöhten Spannung VPP betrieben sind. Durch diese Verwendung von Dünnoxidtransis-toren und Dickoxidtransistoren sowie den Einsatz der Standardversorgungsspannung Vint und der erhöhten Versorgungs-spannung VPP werden möglicherweise vorhandene Schwankungen in diesen Versorgungsspannungen sowie durch den Herstellungsprozess bedingte technologische Schwankungen der Dünnoxidtran-sistoren und Dickoxidtransistoren in beiden Strompfaden besser kompensiert, sodass die Auswirkungen von von einem Standardwert abweichenden Justierungen beispielsweise der erhöhten Versorgungsspannung VPP in beiden Strompfaden automatisch aneinander angeglichen sind. Auch können Fehlfunktionen und Ausbeuteeinbußen auf Grund von herstellungsbedingten Prozessschwankungen weitgehend ausgeschlossen werden.

Damit wird eine hinsichtlich technologischer Schwankungen und Schwankungen der Versorgungsspannungen kompensierte Nachbildung des Zeilenzugriffes bei einem Speicher, insbesondere einem DRAM, möglich, sodass ein optimiertes Sensetiming der Leseverstärker bzw. Senseamps erreicht wird. Dieser wesentliche Vorteil beruht auf dem erstmaligen Einsatz von Dickoxidtransistoren sowie der Verwendung der erhöhten Versorgungsspannung VPP in dem im (zweiten) Strompfad des Startsignales RAVLD liegenden Senseamp-Timer.

Nachfolgend wird die Erfindung anhand der Zeichnungen näher erläutert. Es zeigen:
- Fig. 1: ein schematisches Blockschaltbild eines Ausführungsbeispiels des Senseamp-Timers bzw. des zweiten Strompfades,
- Fig. 2: ein Schaltbild der erfindungsgemäßen Schaltungsanordnung mit dem Senseamp-Timer,
- Fig. 3: ein Schaltbild eines Wortleitung-Timers WLTMR in dem Senseamp-Timer,
- Fig. 4: eine bestehende Schaltungsanordnung mit den beiden Strompfaden und
- Fig. 5: einen bestehenden Senseamp-Timer für einen DRAM.

Die Fig. 4 und 5 sind bereits eingangs erläutert worden. In den Figuren werden für einander entsprechende Bauteile jeweils die gleichen Bezugszeichen verwendet.

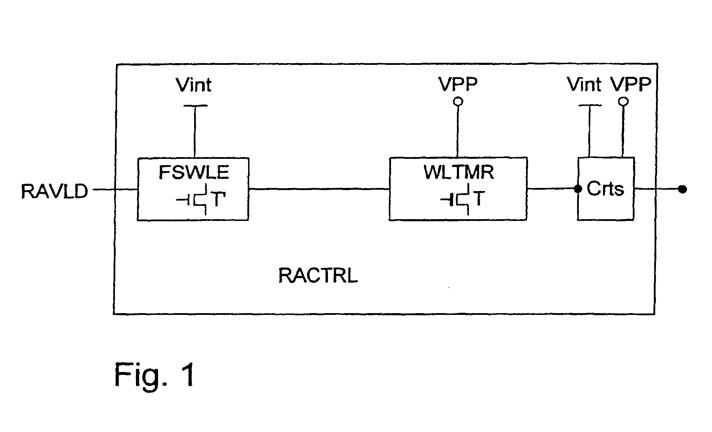

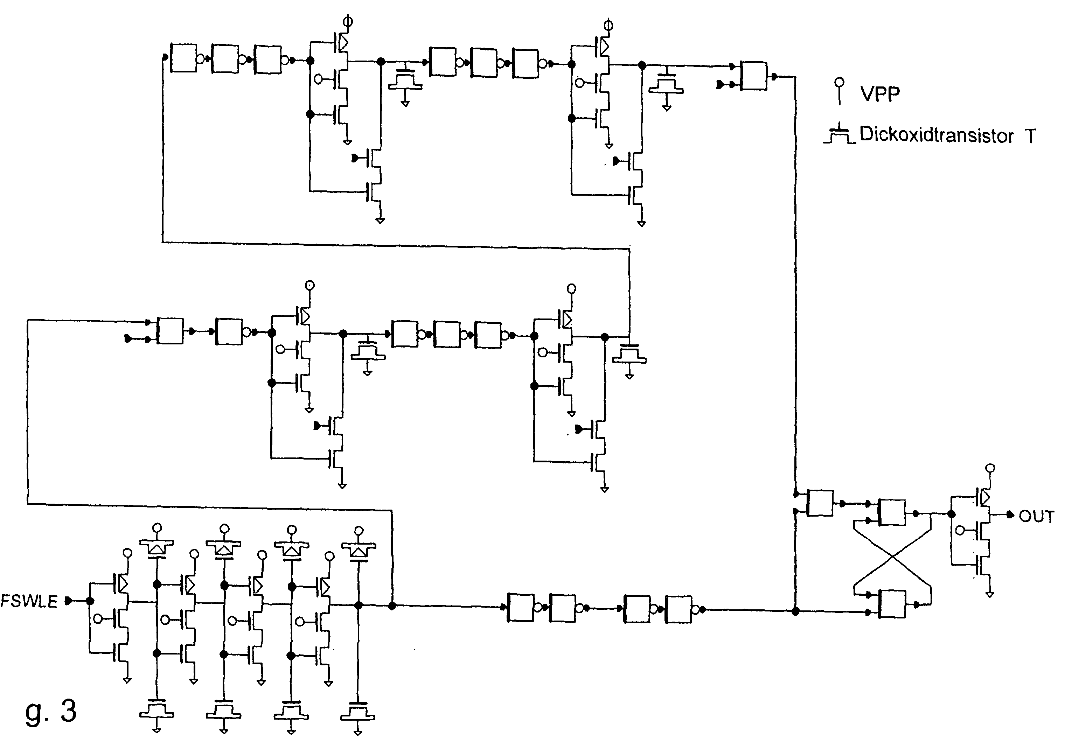

Fig. 1 zeigt ein Ausführungsbeispiel des erfindungsgemäßen Senseamp-Timers RACTRL mit einer Grundverzögerungsschaltung FSWLE, die im Wesentlichen - wie bisher (vgl. Fig. 5) - aus Dünnoxidtransistoren T' und aus solchen bestehenden Invertern aufgebaut ist und mit der Standardversorgungsspannung Vint versorgt ist. Diese Grundverzögerungsschaltung FSWLE ist mit einem Wortleitungstimer WLTMR verbunden, der - wie aus Fig. 3 zu ersehen ist - aus Dickoxidtransistoren T bestehenden Invertern und weiteren Dickoxidtransistoren aufgebaut ist. Diese Dickoxidtransistoren werden mit der erhöhten Versorgungsspannung VPP betrieben. An diesen Wortleitungstimer WLTMR schließen sich weitere Schaltungen Crts mit Invertern, die aus Dickoxidtransistoren bestehen, und Dick- sowie Dünnoxid-transistoren an, wobei die Dickoxidtransistoren jeweils mit der erhöhten Versorgungsspannung VPP und die Dünnoxidtran-sistoren mit der Standardversorgungsspannung Vint versorgt sind.

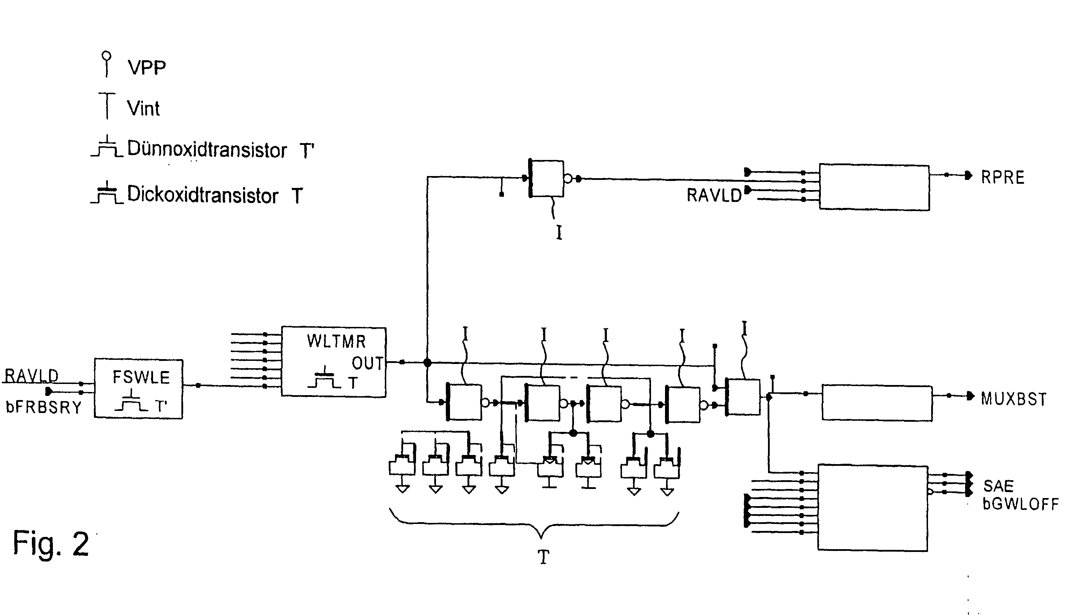

Fig. 2 zeigt ein Ausführungsbeispiel des Senseamp-Timers mit einer Grundverzögerungsschaltung FSWLE, der das Startsignal RAVLD von der zentralen Steuereinheit für einen Quadranten des DRAMs und das Signal bFRBSRY zugeführt sind, dem Wortleitungstimer WLTMR und weiteren Invertern I aus Dickoxidtransistoren T, an denen die erhöhte Versorgungsspannung VPP liegt, und Dünnoxidtransistoren T' (nicht gesondert dargestellt), die teilweise mit der Versorgungsspannung Vint beaufschlagt sind.

Der Aufbau des Wortleitungstimers WLTMR ist aus Fig. 3 ersichtlich. Dieser Wortleitungstimer WLTMR besteht im Wesentlichen aus Invertern, die aus Dickoxidtransistoren aufgebaut sind, und aus weiteren Dickoxidtransistoren. Diese Dickoxidtransistoren sind alle mit der erhöhten Versorgungsspannung VPP beaufschlagt.

Bei der erfindungsgemäßen Schaltungsanordnung ist also die Grundverzögerungsschaltung FSWLE - wie beim Stand der Technik (vgl. Fig. 5) - aus Dünnoxidtransistoren aufgebaut, die mit der Standardversorgungsspannung Vint beaufschlagt sind, während der Wortleitungstimer WLTMR aus Dickoxidtransistoren besteht, die mit der erhöhten Versorgungsspannung VPP versorgt sind. Außerdem sind zusätzliche Inverter bzw. Dünn- und Dickoxidtransistoren vorhanden, wobei jeweils die Dünnoxidtransistoren mit der Standardversorgungsspannung Vint und die Dickoxidtransistoren mit der erhöhten Versorgungsspannung VPP beaufschlagt sind.

### Bezugszeichenliste

- 1: erster Strompfad
- 2: zweiter Strompfad
- 3: Speicherzellenfeld
- 4₁, 4₂, ...: Array-Blocks
- 5: Wortleitungsdecoder
- 6: Steuerschaltung
- 7: Senseamp-Timer
- I: Inverter
- T: Transistoren
- FSWLE: Grundverzögerungsschaltung
- WLTMR: Wortleitungstimer
- RAVLD: Startsignal
- Vint: Standardversorgungsspannung
- VPP: erhöhte Versorgungsspannung
- BL: Bitleitung
- WL: Wortleitung
- SA₁, SA₂, ...: Senseamp
- RACTRL: Senseamp-Timer
- AK: Aktivierungskommando

## Patentansprüche

1. Schaltungsanordnung zur Generierung von LeseverstärkerSteuersignalen für einen Speicher, bei dem über einen ersten Strompfad (1) eine adressierte Wortleitung (WL) des Speichers aktivierbar ist, umfassend einen zweiten Strompfad (2), in dem aus einem von dem ersten Strompfad (1) abgeleiteten Signal (RAVLD) in einer Steuereinrichtung (7) die Leseverstärker-Steuersignale erzeugt sind, und eine Spannungsversorgungseinrichtung (Vint, VPP) für Bauelemente des ersten und des zweiten Strompfades (1, 2),
**dadurch gekennzeichnet, dass**
im zweiten Strompfad (2) zusätzlich zu Dünnoxidtransistoren (T' z. B. in FSWLE) auch Dickoxidtransistoren (T z. B. in WLTMR) vorgesehen sind, und dass von der Spannungsversorgungseinrichtung (Vint, VPP) die Dünnoxidtransistoren (T' z. B. in FSWLE) mit normaler Versorgungsspannung (Vint) und die Dickoxidtransistoren (T z. B. in WLTMR) mit erhöhter Versorgungsspannung (VPP) betrieben sind.

2. Schaltungsanordnung nach Anspruch 1,
**dadurch gekennzeichnet, dass**
eine Grundverzögerungsschaltung (FSWLE) aus Dünnoxidtransistoren und ein Wortleitungstimer (WLTMR) aus Dickoxidtransistoren aufgebaut sind.

## Claims

1. Circuit arrangement for generating sense amplifier control signals for a memory, in which an addressed word line (WL) of the memory can be activated via a first current path (1), comprising a second current path (2), in which the sense amplifier control signals are generated from a signal (RAVLD), derived from the first current path (1), in a control device (7), and a voltage supply device (Vint, VPP) for components of the first and second current paths (1, 2),
**characterized in that**
in the second current path (2), thick oxide transistors (T e.g. in WLTMR) are also provided in addition to thin oxide transistors (T' e.g. in FSWLE), and **in that**, from the voltage supply device (Vint, VPP), the thin oxide transistors , (T' e.g. in FSWLE) are operated with a normal supply voltage (Vint) and the thick oxide transistors (T e.g. in WLTMR) are operated with an increased supply voltage (VPP).

2. Circuit arrangement according to Claim 1,
**characterized in that**
a basic delay circuit (FSWLE) is constructed from thin oxide transistors and a word line timer (WLTMR) is constructed from thick oxide transistors.

## Revendications

1. Circuit de production de signaux de commande d'amplificateur de lecture pour une mémoire, dans lequel il est activé par un premier trajet (1) de courant une ligne (WL) de mots adressée de la mémoire, comprenant un deuxième trajet (2) de courant, dans lequel les signaux de commande d'amplificateur de lecture sont produits dans un dispositif (7) de commande à partir d'un signal (RAVLD) dérivé du premier trajet (1) de courant, et un dispositif (Vint, VPP) d'alimentation en tension pour des composants du premier et du deuxième trajets (1, 2) de courant,
**caractérisé en ce que**,
il est prévu dans le deuxième trajet (2) de courant en plus de transistors (T', par exemple dans FSWLE) à oxyde mince également des transistors (T, par exemple dans WLTMR) à oxyde épais et **en ce que** les transistors (T', par exemple dans FSWLE) à oxyde mince fonctionnent par le dispositif (Vint, VPP) d'alimentation en tension à une tension (Vint) normale d'alimentation et les transistors (T, par exemple dans WLTMR) à oxyde épais fonctionnent à une tension (VPP) plus élevée d'alimentation.

2. Circuit suivant la revendication 1,
**caractérisé en ce qu'**
il est formé un circuit (FSWLE) temporisateur de base constitué de transistors à oxyde mince et un synchroniseur (WLTMR) de lignes de mots constitué de transistors à oxyde épais.
